# EUROPEAN PATENT APPLICATION

(11) **EP 4 793 936 A1**
(43) Date of publication of application: **19.08.2026**
(21) Application number: 25177801.5
(22) Date of filing: 20.05.2025
(51) Int. Cl.: G09G 3/3275, G01R 27/00, G11C 27/02, H03M 1/12

(54) **SENSING CIRCUIT AND DISPLAY DEVICE INCLUDING THE SAME**

(30) Priority: 13.02.2025 KR 20250018584
(71) Applicant: LX Semicon Co., Ltd., Daejeon 34027 (KR)
(72) Inventor: SHIN, Young Ho, 34027 Daejeon (KR); KIM, Won, 34027 Daejeon (KR); KIM, Seong Geon, 34027 Daejeon (KR); KWON, Yong Su, 34027 Daejeon (KR); LEE, Byeon Cheol, 34027 Daejeon (KR)
(74) Representative: Goddar, Heinz J.

(57) **Abstract**

A sensing circuit and a display device include: a first switch (SW1) connected between a first reference voltage line to which a first reference voltage (Vref1) is applied and each of a plurality of sensing lines (SL), a sample and hold part including a first sample and hold part (S/H_1) configured to sample a voltage supplied through a sensing line connected to each of a plurality of first sensing channels and a second sample and hold part (S/H_2) configured to sample a voltage supplied through a sensing line connected to at least one second sensing channel, an amplifier (AMP) configured to receive the sampled voltage from the sample and hold part and amplify the sampled voltage, and an analog-digital -AD- converter (ADC) configured to convert the amplified voltage into digital data and generate sensing data, wherein the second sample and hold part is selectively activated according to a mode control signal (cm1, cmb1, cm2, cmb2).

## Description

### CROSS-REFERENCE TO RELATED APPLICATION

This application claims priority to and the benefit of Korean Patent Application No. 10-2025-0018584, filed on February 13, 2025, the disclosure of which is incorporated herein by reference in its entirety.

### BACKGROUND

### 1. Field of the Invention

Embodiments of the present invention relate to a sensing circuit and a display device including the same.

### 2. Discussion of Related Art

As the information society develops, the demand for display devices for displaying images is increasing in various forms, and recently, various types of display devices such as liquid crystal display (LCD) devices and organic light emitting display (OLED) devices have been utilized.

A display device includes a display panel including a plurality of sub-pixels, a panel driver for driving the display panel, etc. The panel driver includes a data driver for supplying a data voltage to the display panel and a gate driver for supplying a gate signal to the display panel.

In a display device, when driving signals, such as gate signals and data signals, are supplied to the plurality of sub-pixels formed in the display panel, selected sub-pixels may transmit light or directly emit light, thereby displaying an image.

Electrical characteristics of driving elements in the sub-pixels should be identical, but there may be differences in the electrical characteristics between the sub-pixels due to process deviations, changes with time, and long-term power off. Thus, the data driver is further provided with a sensing circuit for sensing electrical characteristics of a sub-pixel through a sensing line, and pixel data of an input image is modulated on the basis of the result detected through the sensing circuit to compensate for an electrical characteristic deviation of the sub-pixels.

However, the number of sensing lines may vary according to the size or resolution of the display panel. Thus, all sensing lines may not be connected to the sensing circuit. Therefore, when the sensing lines are not connected to some sensing channels in the sensing circuit, accurate sensing data cannot be obtained because a voltage is detected while the sensing channel is floating.

### SUMMARY OF THE INVENTION

The present invention is directed to providing a sensing circuit that may be driven selectively, and a display device including the same.

It should be noted that objects of the present invention are not limited to the above-described objects, and other objects of the present invention will be apparent to those skilled in the art from the following descriptions.

According to an aspect of the present invention, there is provided a sensing circuit including a first switch connected between a first reference voltage line to which a first reference voltage is applied and each of a plurality of sensing lines, a sample and hold part including a first sample and hold part configured to sample a voltage supplied through a sensing line connected to each of a plurality of first sensing channels and a second sample and hold part configured to sample a voltage supplied through a sensing line connected to at least one second sensing channel, an amplifier configured to receive the sampled voltage from the sample and hold part and amplify the sampled voltage, and an analog-digital (AD) converter configured to convert the amplified voltage into digital data and generate sensing data, wherein the second sample and hold part is selectively activated according to a mode control signal.

According to another aspect of the present invention, there is provided a display device including a display panel in which pixels are disposed in regions in which a plurality of gate lines and a plurality of data lines intersect, a gate driver configured to output a gate signal through the gate line, a data driver configured to output a data voltage through the data line, and a timing controller configured to control the gate driver and the data driver, wherein the data driver includes a sensing circuit configured to detect electrical characteristics of the pixels and generate sensing data, and the sensing circuit includes a first switch connected between a first reference voltage line to which a first reference voltage is applied and each of a plurality of sensing lines, a sample and hold part including a first sample and hold part configured to sample a voltage supplied through a sensing line connected to each of a plurality of first sensing channels and a second sample and hold part configured to sample a voltage supplied through a sensing line connected to at least one second sensing channel, an amplifier configured to receive the sampled voltage from the sample and hold part and amplify the sampled voltage, and an analog-digital (AD) converter configured to convert the amplified voltage into digital data and generate sensing data, and wherein the second sample and hold part is selectively activated according to a mode control signal.

### BRIEF DESCRIPTION OF THE DRAWINGS

The above and other objects, features and advantages of the present invention will become more apparent to those of ordinary skill in the art by describing exemplary embodiments thereof in detail with reference to the accompanying drawings, in which:
FIG. 1 is a diagram illustrating a display device according to an embodiment of the present invention;
FIG. 2 is a diagram illustrating a pixel circuit according to an embodiment of the present invention;
FIG. 3 is a diagram illustrating a configuration of a data driver according to an embodiment of the present invention;
FIGS. 4 and 5 are diagrams illustrating a sensing circuit according to a first embodiment of the present invention;
FIGS. 6A and 6B are diagrams illustrating an arrangement form of a sample and hold part shown in FIG. 4;
FIGS. 7A and 7B are diagrams illustrating activation/deactivation states of the sample and hold part;
FIGS. 8 and 9 are diagrams illustrating driving timings of the sensing circuit according to the embodiment of the present invention;
FIGS. 10 and 11 are diagrams for describing an operating principle of the sensing circuit shown in FIG. 8;
FIGS. 12 and 13 are diagrams illustrating a sensing circuit according to a second embodiment of the present invention; and
FIGS. 14 and 15 are diagrams illustrating offset values of the sample and hold part according to channels.

### DETAILED DESCRIPTION OF EXEMPLARY EMBODIMENTS

Advantages, features, and implementations thereof will be apparent from embodiments which are described in detail below together with the accompanying drawings. The present invention may be implemented in many different forms and should not be construed as being limited to the embodiments set forth herein, the embodiments are provided such that this disclosure will be thorough and complete and will fully convey the scope of the present invention to those skilled in the art to which the present invention pertains, and the present invention is defined by only the scope of the appended claims.

Shapes, sizes, ratios, angles, numbers, and the like disclosed in the drawings for describing the embodiments of the present invention are illustrative, and thus the present invention is not limited to the illustrated matters. The same reference numerals refer to substantially the same components throughout the present specification. Further, in the following description of the present invention, when detailed description of a known related art is determined to unnecessarily obscure the gist of the present invention, the detailed description thereof will be omitted herein.

When the terms "provided with," "including," "having," "consisting of," and the like mentioned in the present invention are used, other parts may be added unless the term "only" is used herein. When a component is expressed as a singular number, the singular number can be construed as a plural number unless otherwise specified.

In analyzing a component, it is interpreted as including an error range even when there is no explicit description.

When the positional relationship and interconnection between two components are described, such as with "on," "above," "below," "next to," "connected or coupled," "crossing or intersecting," etc., one or more other components may be interposed between these components, unless there is a mention of "immediately" or "directly."

When a temporal predecessor relationship is described as being "after," "subsequent," "next to," "prior to," or the like, unless "immediately" or "directly" is used, cases may not be continuous on the time axis.

In order to distinguish components, "first," "second," etc., may be used before the name of the component, but this ordinal number or component name does not limit its function or structure. For convenience of description, ordinal numbers preceding the names of identical components may differ between embodiments.

The following embodiments can be partially or fully coupled to or combined with each other, and various technological interconnections and drives are possible. The embodiments may each be implemented independently from each other or may be implemented together in association.

Hereinafter, various embodiments of the present invention will be described in detail with reference to the accompanying drawings.

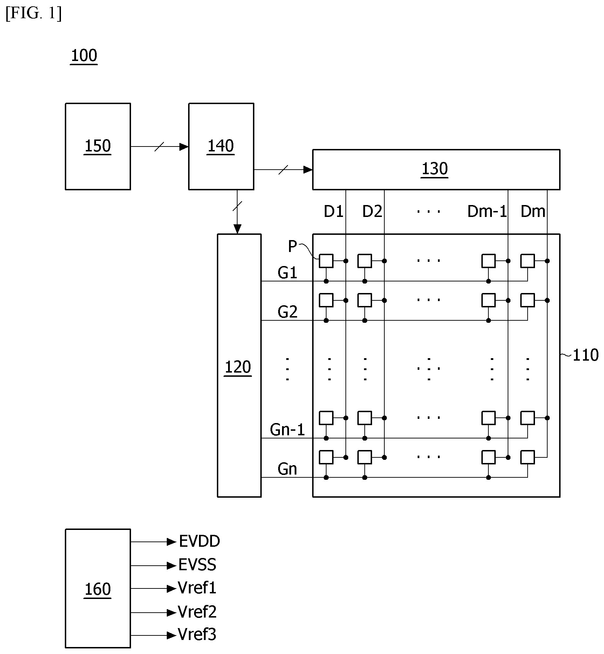

FIG. 1 is a diagram illustrating a display device according to an embodiment of the present invention.

Referring to FIG. 1, a display device 100 according to the embodiment of the present invention may include a display panel 110 and a display driving circuit for driving the display panel 110. The display driving circuit may include a gate driver 120, a data driver 130, and a timing controller 140. The display device may further include a host system 150 that supplies various timing signals to the timing controller 140. In addition, the display device may further include a power supply 160.

The display panel 110 may include a plurality of gate lines G1 to Gn and a plurality of data lines D1 to Dm, which are disposed to intersect each other and define a plurality of pixel regions, and pixels P provided in the plurality of pixel regions.

The pixels P may be classified into a red sub-pixel (R) that emits red light, a green sub-pixel (G) that emits green light, and a blue sub-pixel (B) that emits blue light for color implementation, but the present invention is not limited thereto. Each of the red, green, and blue sub-pixels (R, G, and B) may include a pixel circuit. Hereinafter, the "pixel" may be construed as the "sub-pixel."

As shown in the drawings, the gate driver 120 may be disposed on one side of the display panel 110, for example, on the left side, but in some cases, the gate driver 120 may be disposed on one side and the other side of the display panel 110 opposite to each other, for example, on both left and right sides. The gate driver 120 may include a plurality of gate driver integrated circuits (ICs) (not shown).

The gate driver 120 may be in the form of a tape carrier package on which the gate driver ICs are mounted, but the present invention is not necessarily limited thereto, and the gate driver ICs may be mounted directly on the display panel 110.

The data driver 130 converts a digital image signal, which is transmitted from the timing controller 140, into an analog data voltage and outputs the analog data voltage to the display panel 110. Specifically, in response to a data control signal DCS transmitted from the timing controller 140, the data driver 130 outputs the analog data voltage to the data lines D1 to Dm.

The data driver 130 may be disposed on one side of the display panel 110, for example, on the upper side, but in some cases, the data driver 130 may be disposed on one side and the other side of the display panel 110 opposite to each other, for example, on both upper and lower sides. In addition, the data driver 130 may be in the form of a tape carrier package on which source driver ICs are mounted, but the present invention is not necessarily limited thereto.

The timing controller 140 receives various timing control signals including a vertical synchronization signal Vsync, a horizontal synchronization signal Hsync, a data enable (DE) signal, and a clock signal CLK from the host system 150 and generates a data control signal DCS for controlling the data driver 130 and a gate control signal GCS for controlling the gate driver 120.

In addition, the timing controller 140 may receive image data from the host system 150, convert the image data into image data in a form that can be processed by the data driver 130, and output the converted image data.

The data control signal DCS may include a source start pulse SSP, a source sampling clock SSC, and a source output enable signal SOE. The gate control signal GCS may include a gate start pulse GSP, a gate shift clock GSC, and a gate output enable signal GOE.

The host system 150 may be implemented as any one of a navigation system, a set-top box, a digital versatile disc (DVD) player, a blu-ray player, a personal computer (PC), a home theater system, a broadcast receiver, and a phone system.

The host system 150 includes a system on chip (SoC) in which a scaler is embedded and may convert digital image data RGB of an input image into a format suitable for display on the display panel 110. The host system 150 may transmit the digital image data of the input image and various timing control signals to the timing controller 140.

The power supply 160 receives an input voltage applied from the host system 150 and outputs voltages required for driving the pixels P of display panel 110 and the display driving circuit. The power supply 160 may output constant voltages (or DC voltages) such as a pixel driving voltage EVDD, a pixel base voltage EVSS, and a reference voltage Vref through a DC-DC converter. The voltages such as the pixel driving voltage EVDD, the pixel base voltage EVSS, and the reference voltage Vref may be supplied to the pixels P through power lines commonly connected to the pixels P.

The reference voltage Vref includes a first reference voltage Vrefl, a second reference voltage Vref2, and a third reference voltage Vref3. The second reference voltage Vref2 may have a value that is less than or equal to that of the first reference voltage Vrefl, and a value of the third reference voltage Vref3 may be set to be less than that of the second reference voltage Vref2.

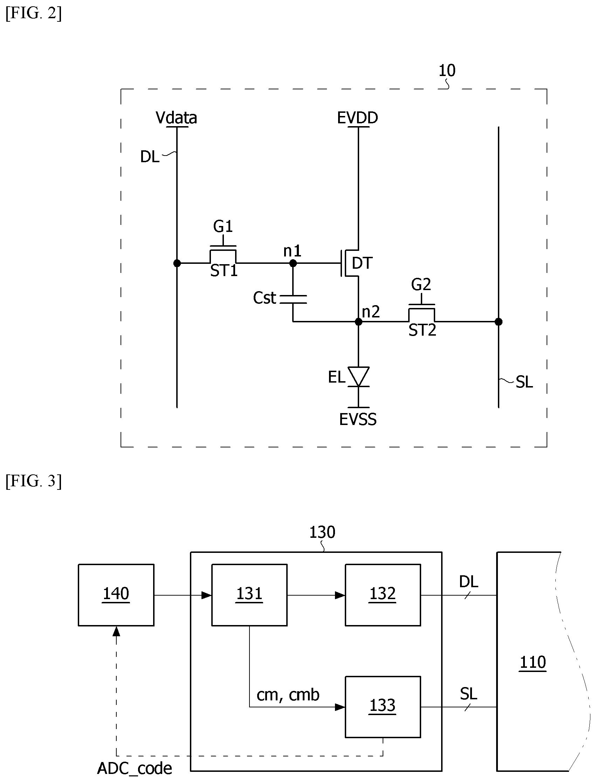

FIG. 2 is a diagram illustrating a pixel circuit according to an embodiment of the present invention.

Referring to FIG. 2, each sub-pixel P according to the embodiment of the present invention includes a pixel circuit 10, and the pixel circuit 10 may include a light-emitting element EL, a driving element DT, a first switch element ST1, a second switch element ST2, and a storage capacitor Cst.

The light-emitting element EL emits light by a current applied through a channel of the driving element DT according to a gate-source voltage Vgs of the driving element DT, which varies according to a data voltage Vdata.

The driving element DT supplies a current to the light-emitting element EL according to the gate-source voltage Vgs to drive the light-emitting element EL.

The first switch element ST1 is turned on according to a gate-on voltage of a first gate signal G1 and applies the data voltage Vdata, which is supplied from the data driver through a data line DL, to a first node n1.

The second switch element ST2 is turned on according to a gate-on voltage of a second gate signal G2 and applies the reference voltage Vref, which is supplied through a sensing line SL, to a second node n2.

The storage capacitor Cst is connected between the first node n1 and the second node n2. The storage capacitor Cst may be charged with the gate-source voltage Vgs of the driving element DT.

In the embodiment, electrical characteristics of the pixel circuit 10 may be detected through the sensing line SL, and thus an electrical characteristic deviation of the pixel circuit 10 may be compensated for using the detected data. Here, the electrical characteristics of the pixel circuit may include, for example, a threshold voltage of the driving element, mobility of the driving element, a driving voltage (or threshold voltage) of the light-emitting element, etc.

FIG. 3 is a diagram illustrating a configuration of a data driver according to an embodiment of the present invention.

Referring to FIG. 3, the data driver 130 according to the embodiment of the present invention may include a control circuit 131, an output circuit 132, and a sensing circuit 133.

The control circuit 131 may receive the image data and control data from the timing controller 140 and transmit the image data to the output circuit 132 on the basis of the received control data. Here, the control data may include the timing control signals and channel mode information in which the number of channels used is set according to a size and resolution of the display panel. For example, the channel mode information may include first channel mode information using 240 sensing channels and second channel mode information using 120 sensing channels, but the present invention is not limited thereto.

The control circuit 131 may generate a mode control signal for controlling a switch within the sensing circuit 133 according to the channel mode information and apply the generated mode control signal to the sensing circuit 133. Here, the mode control signal may include a pair of a first mode control signal cmb and a second mode control signal cm. In addition to the mode control signal, the control circuit 131 may provide switch control signals for controlling switches within the sensing circuit.

The output circuit 132 may convert digital image data into an analog data voltage and supply the converted analog data voltage to the pixels in the display panel 110 through the data lines DL. The output circuit 132 may include a shift register, a latch, a level shifter, a digital-to-analog (DA) converter, and an output buffer, but the present invention is not limited thereto.

The sensing circuit 133 may detect the electrical characteristics of the pixels in the display panel 110 through the sensing lines SL, generate sensing data, and provide the generated sensing data to the timing controller 140. The sensing circuit 133 may include sensing channels connected to the sensing lines SL and selectively activate or deactivate some of the sensing channels.

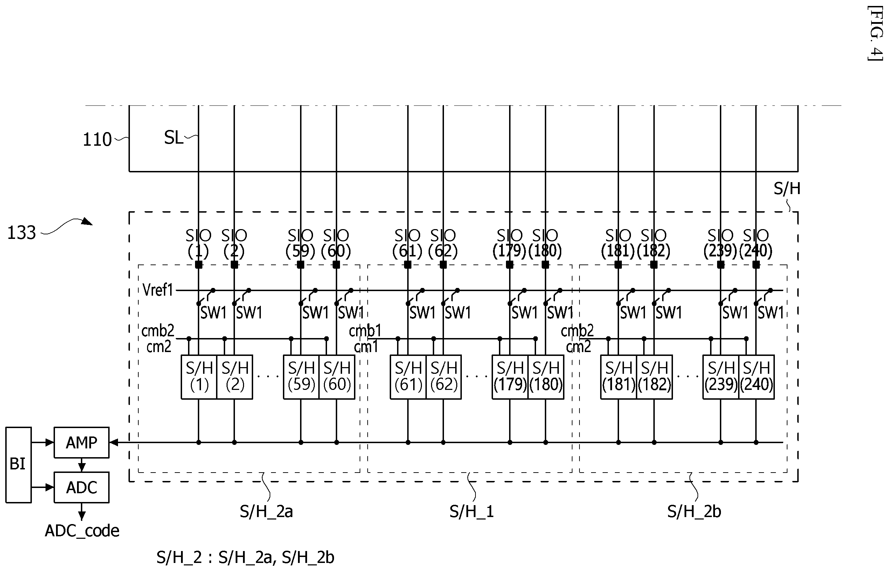

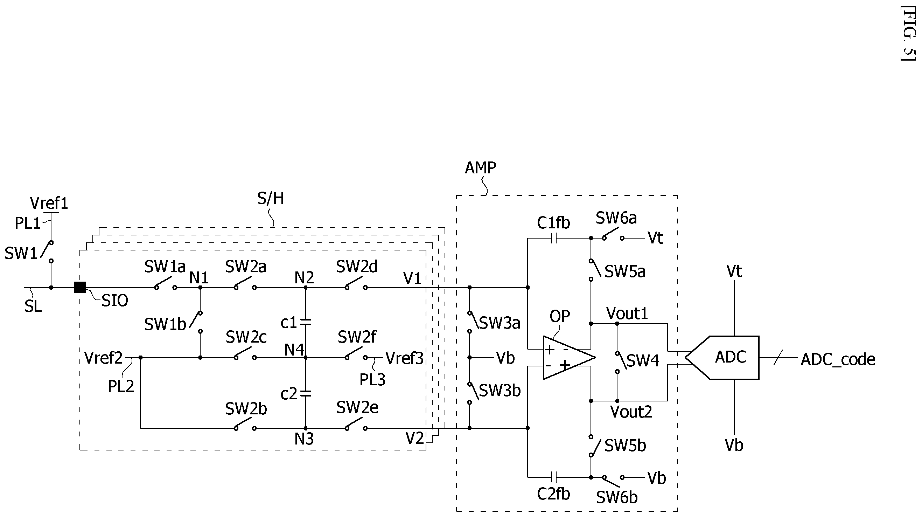

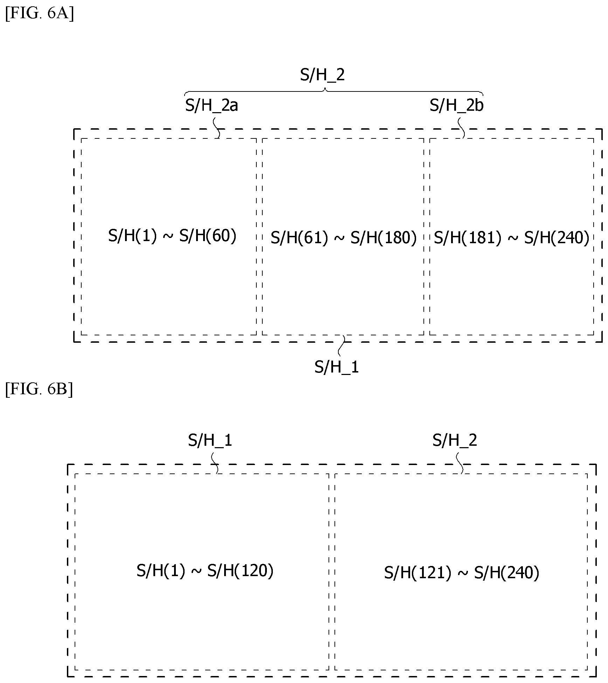

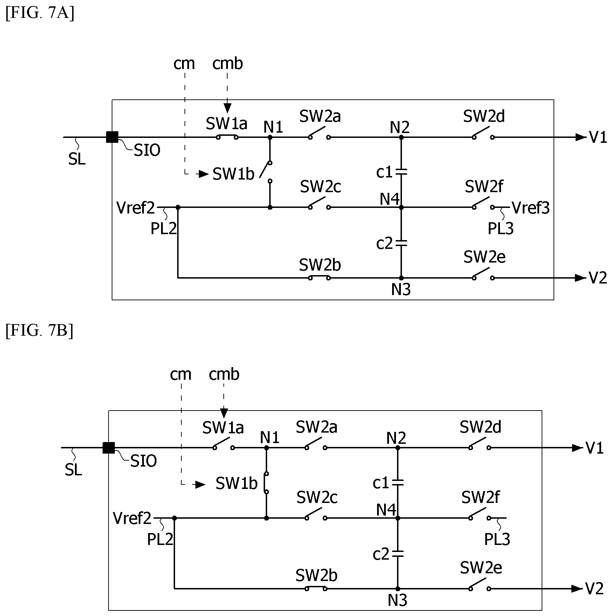

FIGS. 4 and 5 are diagrams illustrating a sensing circuit according to a first embodiment of the present invention, FIGS. 6A and 6B are diagrams illustrating an arrangement form of a sample and hold part shown in FIG. 4, and FIGS. 7A and 7B are diagrams illustrating activation/deactivation states of the sample and hold part.

Referring to FIGS. 4 and 5, the sensing circuit 133 according to the first embodiment of the present invention may include a bias part BI, a first switch SW1, a sample and hold part S/H, an amplifier AMP, and an AD converter ADC.

The bias part BI may generate and supply a bias voltage Vbias for driving the amplifier AMP and the AD converter ADC. The bias voltage Vbias may include a first bias voltage Vt that is a high-potential voltage, and a second bias voltage Vb that is a low-potential voltage.

The first switch SW1 is connected between the sensing line SL and a first reference voltage line PL1 to which the first reference voltage Vref1 is applied. The first switch SW1 is turned on according to the switch control signal to apply the first reference voltage Vref1 to the sensing line SL.

In this case, the first reference voltage Vref1 may be used when driven in an analog-digital conversion (ADC) compensation mode for compensating for errors of the sensing data generated by the AD converter ADC in the sensing circuit and in a panel compensation mode for compensating for an electrical characteristic deviation of the driving elements in the pixel circuit. For example, in the ADC compensation mode, the first reference voltage Vref1 supplied to the sensing line is sampled. In the panel compensation mode, a source node of the driving element in the pixel circuit is initialized at the first reference voltage Vref1.

The sample and hold part S/H is connected to the sensing line SL for each of sensing channels SIO(1) to SIO(240) and may sample a voltage supplied through the sensing line SL. In this case, the sample and hold part S/H may be divided into a plurality of sample and hold parts. As shown in FIGS. 6A and 6B, the sample and hold part S/H may include a first sample and hold part S/H_1 and a second sample and hold part S/H_2.

As shown in FIG. 6A, two second sample and hold parts S/H_2 (S/H_2a and S/H_2b) are disposed on both sides of the first sample and hold part S/H_1, or as shown in FIG. 6B, the second sample and hold part S/H_2 is disposed on one side of the first sample and hold part S/H_1, but the present invention is not limited thereto. The second sample and hold part S/H_2 can be implemented with at least one sample and hold circuit. An example in which all 240 sensing channels are used or 120 of the 240 sensing channels are used is shown in FIGS. 6A and 6B, but the present invention is not limited thereto.

The first sample and hold part S/H_1 may always be activated regardless of the channel mode information. The second sample and hold part S/H_2 may be activated or deactivated according to the channel mode information.

For example, both of the first sample and hold part S/H_1 and the second sample and hold part S/H_2 may be activated according to the first channel mode information. According to the second channel mode information, the first sample and hold part S/H_1 may be activated, and the second sample and hold part S/H_2 may be deactivated.

The pair of the first mode control signal cmb and the second mode control signal cm according to channel mode information may be applied to each of the first sample and hold part S/H_1 and the second sample and hold part S/H_2.

The sample and hold part S/H may include a plurality of sample and hold circuits S/H(1) to S/H(m). 120 sample and hold circuits S/H(61) to S/H(180) may be disposed in the first sample and hold part S/H_1, and 120 sample and hold circuits S/H(1) to S/H(60) and S/H(181) to S/H(240) may be disposed in the second sample and hold part S/H_2. Each sample and hold circuit S/H#m may include a first mode switch SW1a, a second mode switch SW1b, first to sixth sensing switches SW2a to SW2f, a first capacitor C1, and a second capacitor C2.

The first mode switch SW1a is connected between a sensing channel SIO(m) and a first connection node N1. The second mode switch SW1b is connected between the first connection node N1 and a second reference voltage line PL2. The first mode switch SW1a and the second mode switch Sw1b may be turned on or off by the first mode control signal cmb and the second mode control signal cm, respectively, which are generated according to the channel mode information. The first mode control signal cmb and the second mode control signal cm may have opposite phases.

The first mode switch SW1a is turned on by a logic high level of the first mode control signal cmb, and the second mode switch SW1b is turned on by a logic high level of the second mode control signal cm.

As shown in FIG. 7A, the first mode control signal cmb of a logic high level and the second mode control signal cm of a logic low level may be applied to the sample and hold circuit disposed in the sample and hold part that is activated according to the channel mode information. The first mode switch Sw1a may be turned on by the first mode control signal cmb of a logic high level to connect the sensing channel SIO(m) and the first connection node N1, and the second mode switch Sw1b may be turned off by the second mode control signal cm of a logic low level.

As shown in FIG. 7B, the first mode control signal cmb of a logic low level and the second mode control signal cm of a logic high level may be applied to the sample and hold circuit disposed in the sample and hold part that is deactivated according to the channel mode information. The first mode switch SW1a is turned off by the first mode control signal (cmb) of a logic low level, and the second mode switch SW1b is turned on by the second mode control signal cm of a logic high level, so that the first connection node N1 and the second reference voltage line PL2 may be connected.

The first sensing switch SW2a is connected between the first connection node N1 and a second connection node N2. The second sensing switch SW2b is connected between the second reference voltage line PL2 and a third connection node N3. The third sensing switch SW2c is connected between the second reference voltage line PL2 and a fourth connection node N4. The fourth sensing switch SW2d is connected between the second connection node N2 and a first input terminal + of the amplifier AMP. The fifth sensing switch SW2e is connected between the third connection node N3 and a second input terminal - of the amplifier AMP. The sixth sensing switch SW2f is connected between the fourth connection node N4 and a third reference voltage line PL3 to which the third reference voltage is applied. The first capacitor C1 is connected between the second connection node N2 and the fourth connection node N4. The second capacitor C2 is connected between the third connection node N3 and the fourth connection node N4.

When the first and second sensing switches SW2a and SW2b are turned on while the first mode switch SW1a is turned on and the second mode switch SW1b is turned off, which are provided in the sample and hold circuit, a voltage supplied through the sensing line SL connected to the sensing channel is sampled, and thus a sampled first voltage V1 is stored in the first capacitor C1, and a voltage supplied through the second reference voltage line PL2 is sampled, and thus a sampled second voltage V2 is stored in the second capacitor C2.

In this case, since the second reference voltage Vref2 is applied to both terminals of the second capacitor C2, the second voltage V2 becomes 0 V. This second voltage V2 is input differentially to the amplifier AMP together with the first voltage V1 and serves as a reference voltage for differential amplification with the first voltage V1. Therefore, in order to remove noise that may occur when the second reference voltage Vref2 is generated, the same voltage is applied to both terminals of the second capacitor C2 to generate a voltage of 0 V in which the noise is offset.

When the fourth and fifth sensing switches SW2d and SW2e are turned on, the first voltage V1 stored in the first capacitor C1 is input to the first input terminal + of the amplifier AMP, and the second voltage V2 stored in the second capacitor C2 is input to the second input terminal - of the amplifier AMP.

The amplifier AMP may amplify and output the voltage sampled from the sample and hold part S/H. The amplifier AMP may be implemented as a differential amplifier with two inputs and two outputs. The amplifier AMP may differentially amplify the first voltage V1 and the second voltage V2, which are input from the sample and hold part S/H, and output a first output voltage Vout1 and a second output voltage Vout2.

The amplifier AMP includes an operational amplifier OP, a first feedback capacitor C1fb and a first feedback switch SW5a connected between a first input terminal, which is a non-inverted input terminal (+), and a first output terminal, which is an inverted output terminal (-), of the operational amplifier OP, a second feedback capacitor C2fb and a second feedback switch SW5b connected between a second input terminal, which is an inverted input terminal (-) of the operational amplifier OP, and a second output terminal, which is a non-inverted output terminal (+), a first input reset switch SW3a connected between the first input terminal + of the operational amplifier OP and a power line to which the first bias voltage Vt is applied, and a second input reset switch SW3b connected between the second input terminal - of the operational amplifier OP and the power line to which the first bias voltage Vt is applied, an output reset switch SW4 connected between the first output terminal - and the second output terminal +, a first feedback reset switch SW6a connected between a connection node of the first feedback capacitor C1fb and the first feedback switch SW5a and the power line to which the first bias voltage Vt is applied, and a second feedback reset switch SW6b connected between a connection node of the second feedback capacitor C2fb and the second feedback switch SW5b and the power line to which the second bias voltage Vb is applied.

The AD converter ADC may convert the amplified voltage from the amplifier AMP into digital sensing data. The AD converter ADC converts a difference between the first output voltage Vout1 and the second output voltage Vout2, which are output from the amplifier AMP, into digital sensing data ADC_code.

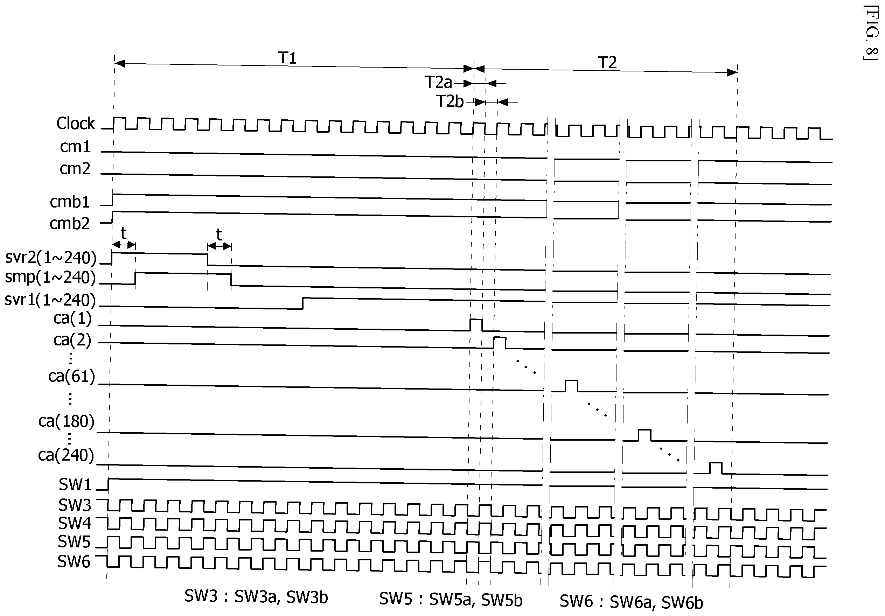

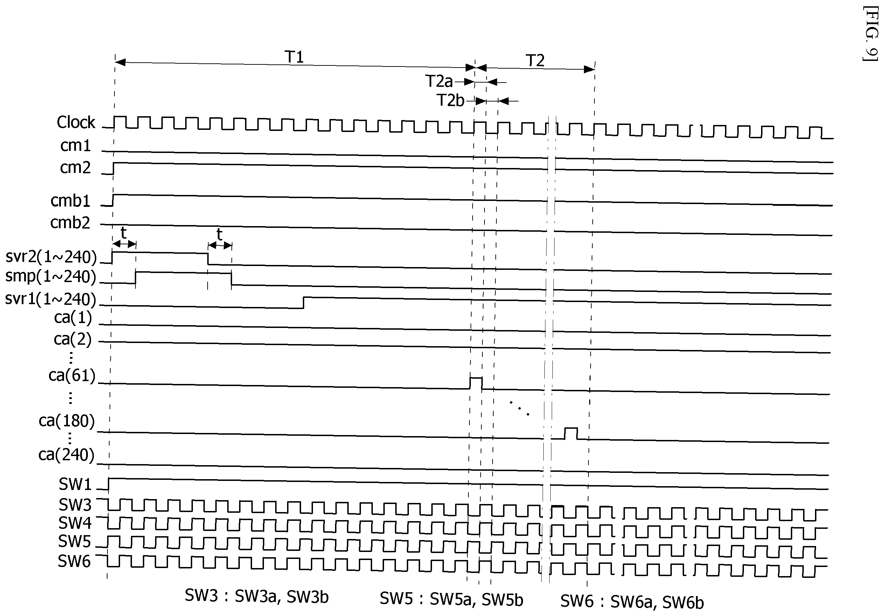

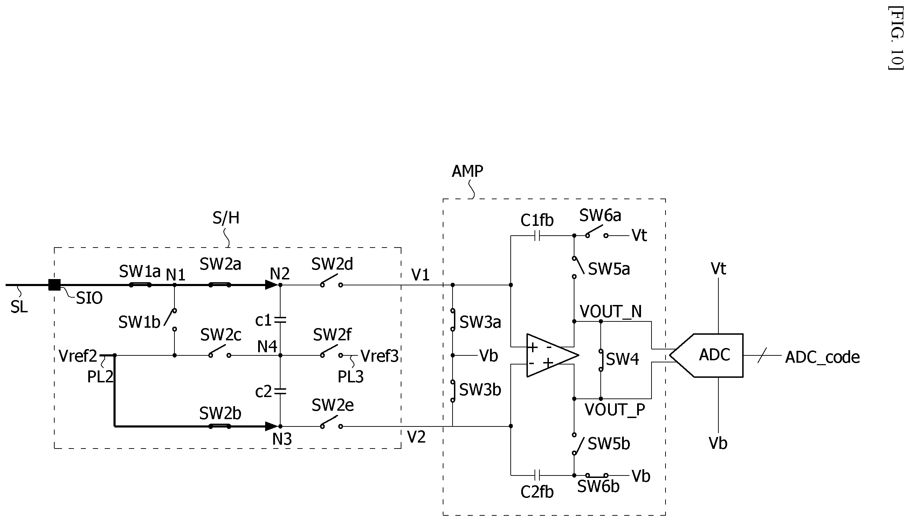

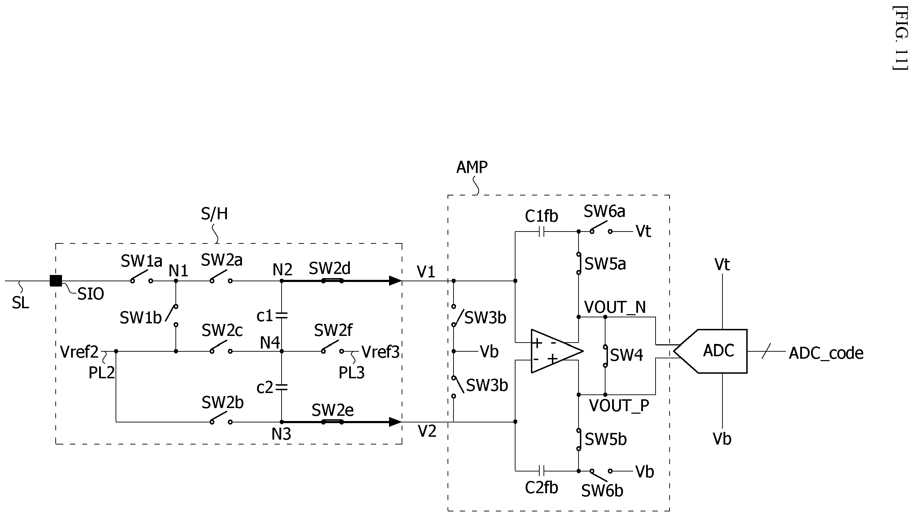

FIGS. 8 and 9 are diagrams illustrating driving timings of the sensing circuit according to the embodiment of the present invention, and FIGS. 10 and 11 are diagrams for describing an operating principle of the sensing circuit shown in FIG. 8.

Here, a case in which the first switch SW1 is turned on will be described based on the ADC compensation mode. In the panel compensation mode, only the first switch SW1 is turned off, and other driving timings may be the same. In addition, first mode control signals cm1 and cm2 are applied to the first mode switch SW1a, second mode control signals cmb1 and cmb2 are applied to the second mode switch SW1b, a switch control signal smp is applied to the first and second sensing switches SW2a and SW2b, a switch control signal svr2 is applied to the third sensing switch SW2c, switch control signals ca(1) to ca(240) are applied to the fourth and fifth sensing switches SW2d and SW2e, and a switch control signal svr1 is applied to the sixth sensing switch SW2f.

Referring to FIGS. 8, 10, and 11, the ADC compensation mode in which the sensing is performed through the 240 sensing channels includes a first section T1 in which sampling is performed and a second section T2 in which amplification is performed.

As shown in FIGS. 8 and 10, during the first section T1, the first mode switches SW1a of all of the sample and hold circuits included in the first and second sample and hold parts are turned on by a logic high level H of the first mode control signal cmb, and the second mode switches SW1b are turned off by a logic low level L of the second mode control signal cm. After the third sensing switch SW2c is turned on, the first and second sensing switches SW2a and SW2b are turned on, and the fourth to sixth sensing switches SW2d to SW2f are turned off.

The first to third sensing switches SW2a to SW2c are turned on, the voltage supplied through the sensing line SL is sampled, and thus the sampled first voltage V1 is stored in the first capacitor C1, and the voltage supplied through the second reference voltage line PL2 is sampled, and thus the sampled second voltage V2 is stored in the second capacitor C2.

In this case, the first reference voltage Vref1 is applied to one end of the first capacitor C1 and the second reference voltage Vref2 is applied to the other end, and thus a difference in voltage between the first reference voltage Vref1 and the second reference voltage Vref2 is stored in the first capacitor C1. Since an overvoltage may occur instantaneously when the first reference voltage Vref1 and the second reference voltage Vref2 are simultaneously applied to both ends of the first capacitor C1, the first reference voltage Vref1 and the second reference voltage Vref2 are applied sequentially. That is, the switch control signal svr2 rises to a logic high level, and after a predetermined time t elapses, the switch control signal smp rises to a logic high level. Similarly, the switch control signal svr2 drops to a logic low level, and after the predetermined time t elapses, the switch control signal smp drops to a logic low level.

The first and second sensing switches SW2a and SW2c are turned on simultaneously in all the sensing channels.

Thereafter, the first to fifth sensing switches SW2a to SW2e are turned off, the sixth sensing switch SW2f is turned on, the third reference voltage Vref3 is applied to a connection node of the first capacitor C1 and the second capacitor C2, and thus a level of the first voltage V1 charged in the first capacitor C1 is lowered.

For example, when Vref1=10 V, Vref2=5 V, and Vref3=1 V, after 10 V is applied to one end of the first capacitor and 5 V is applied to the other end, and when the voltage of the other end of the first capacitor is lowered to 1 V by the third reference voltage Vref3, the voltage of one end of the first capacitor is also lowered to 6 V.

The reason for this is that, since the level of the voltage being sampled is high, processing is performed after the level of the voltage is lowered. Accordingly, the first switch SW1, the first and second mode switches SW1a and SW1b, and the first to sixth sensing switches SW2a to SW2f may be implemented as high voltage (HV) switches, and the first and second input reset switches SW3a and SW3b, the output reset switch SW4, the first and second feedback switches SW5a and SW5b, and the first and second feedback reset switches SW6a and SW6b may be implemented as low voltage (LV) switches.

In this case, as shown in FIG. 10, in the amplifier AMP, the first and second input reset switches SW3a and SW3b, the output reset switch SW4, and the first and second feedback reset switches SW6a and SW6b are turned on, and the first and second feedback switches SW5a and SW5b are turned off, and thus the first and second input terminals + and - and the first and second output terminals - and + of the operational amplifier OP are initialized by the second bias voltage Vb.

As shown in FIGS. 8 and 11, during the second section T2, in the sample and hold S/H, the first to third sensing switches SW2a and SW2c and the sixth sensing switch SW2f of are turned off, and the fourth and fifth sensing switches SW2d and SW2e may be sequentially turned on for each sensing channel.

During the second section T2, a second a section T2a and a second b section T2b for each sensing channel may repeat. The second a section T2a may be a section in which the sampled value is amplified, and the second b section T2b may be a section in which the input terminals and output terminals of the amplifier are initialized.

During the second a section T2a, when the first to third sensing switches SW2a to SW2c and the sixth sensing switch SW2f are turned off and the fourth and fifth sensing switches SW2d and SW2e are turned on in the sample and hold S/H, the first voltage V1 stored in the first capacitor C1 is input to the first input terminal + of the amplifier AMP, and the second voltage V2 stored in the second capacitor C2 is input to the second input terminal - of the amplifier AMP.

In this case, as shown in FIG. 11, in the amplifier AMP, the first and second input reset switches SW3a and SW3b, the output reset switch SW4, and the first and second feedback reset switches SW6a and SW6b are turned on, and the first and second feedback switches SW5a and SW5b are turned off, and thus the first voltage V1 and the second voltage V2 are differentially input to the first and second input terminals + and - of the operational amplifier OP.

The first output voltage Vout1 is output from the first output terminal - of the operational amplifier OP, and the second output voltage Vout2 is differentially output from the second output terminal +, and thus the first and second output voltages Vout1 and Vout2 are input to the AD converter ADC.

During the second b section T2b, in the sample and hold S/H, the first to sixth sensing switches SW2a to SW2f are turned off, the first and second input reset switches SW3a and SW3b, the output reset switch SW4, and the first and second feedback reset switches SW6a and SW6b are turned on, and the first and second feedback switches SW5a and SW5b are turned off, and thus the first and second input terminals + and - of the operational amplifier OP are initialized by the second bias voltage Vb, the first output terminal - of the operational amplifier OP is initialized by the first bias voltage Vt, and the second output terminal of the operational amplifier OP is initialized by the second bias voltage Vb.

The AD converter ADC receives the first output voltage Vout1 and the second output voltage Vout2, which are differentially output from the amplifier AMP, and converts the first output voltage Vout1 and the second output voltage Vout2 into digital sensing data ADC_code.

Referring to FIGS. 9, 10, and 11, the ADC compensation mode in which the sensing is performed through the 120 sensing channels includes a first section T1 in which sampling is performed and a second section T2 in which holding and amplification are performed.

As shown in FIGS. 9 and 10, during the first section T1, the first mode switch SW1a of the sample and hold circuit included in the first sample and hold part is turned on by a logic high level H of the first mode control signal cmb, and the second mode switch SW1b is turned off by a logic low level L of the second mode control signal cm.

After the third sensing switch SW2c is turned on, the first and second sensing switches SW2a and SW2b are turned on, and the fourth to sixth sensing switches SW2d to SW2f are turned off.

The first to third sensing switches SW2a to SW2c are turned on, the voltage supplied through the sensing line SL is sampled, and thus the sampled first voltage V1 is stored in the first capacitor C1, and the voltage supplied through the second reference voltage line PL2 is sampled, and thus the sampled second voltage V2 is stored in the second capacitor C2.

On the other hand, the first mode switch SW1a of the sample and hold circuit included in the second sample and hold part is turned off by a logic low level L of the first mode control signal cmb, and the second mode switch SW1b is turned on by a logic high level H of the second mode control signal cm.

An operation of the sample and hold circuit included in the first sample and hold part is the same as that in FIGS. 8 and 10. However, the only difference is that the sampling and holding operations are performed only during the first sample and hold part, and the sampling and holding operations are not performed in the second sample and hold part.

Thereafter, the first to fifth sensing switches SW2a to SW2e are turned off, the sixth sensing switch SW2f is turned on, the third reference voltage Vref3 is applied to a connection node of the first capacitor C1 and the second capacitor C2, and thus a level of the first voltage C1 charged in the first capacitor C1 is lowered.

In this case, as shown in FIG. 10, in the amplifier AMP, the first and second input reset switches SW3a and SW3b, the output reset switch SW4, and the first and second feedback reset switches SW6a and SW6b are turned on, and the first and second feedback switches SW5a and SW5b are turned off, and thus the first and second input terminals + and - and the first and second output terminals - and + of the operational amplifier OP are initialized by the second bias voltage Vb.

As shown in FIGS. 9 and 11, during the second section T2, in the sample and hold circuit included in the first sample and hold part, the first to third sensing switches SW2a and SW2c and the sixth sensing switch SW2f are turned off, and the fourth and fifth sensing switches SW2d and SW2e are sequentially turned on for each sensing channel.

During the second section T2, a second a section T2a and a second b section T2b for each sensing channel may repeat. The second a section T2a may be a section in which the sampled value is amplified, and the second b section T2b may be a section in which the input terminals and output terminals of the amplifier are initialized.

During the second a section T2a, when the fourth and fifth sensing switches SW2d and SW2e are turned on, the first voltage V1 stored in the first capacitor C1 is input to the first input terminal + of the amplifier AMP, and the second voltage V2 stored in the second capacitor C2 is input to the second input terminal - of the amplifier AMP.

On the other hand, the first and second sensing switches SW2a and SW2b and the fourth and fifth sensing switches SW2d and SW2e of the sample and hold circuit included in the second sample and hold part are turned off.

An operation of the sample and hold circuit included in the first sample and hold part is the same as that in FIGS. 8 and 11. However, the only difference is that the sampled voltage is output only in the first sample and hold part, and no sampling is performed in the second sample and hold part.

In this case, as shown in FIG. 11, in the amplifier AMP, the first and second input reset switches SW3a and SW3b, the output reset switch SW4, and the first and second feedback reset switches SW6a and SW6b are turned on, and the first and second feedback switches SW5a and SW5b are turned off, and thus the first voltage V1 and the second voltage V2 are differentially input to the first and second input terminals + and - of the operational amplifier OP.

The AD converter ADC receives the first output voltage Vout1 and the second output voltage Vout2, which are differentially output from the amplifier AMP, and converts the first output voltage Vout1 and the second output voltage Vout2 into digital sensing data ADC_code.

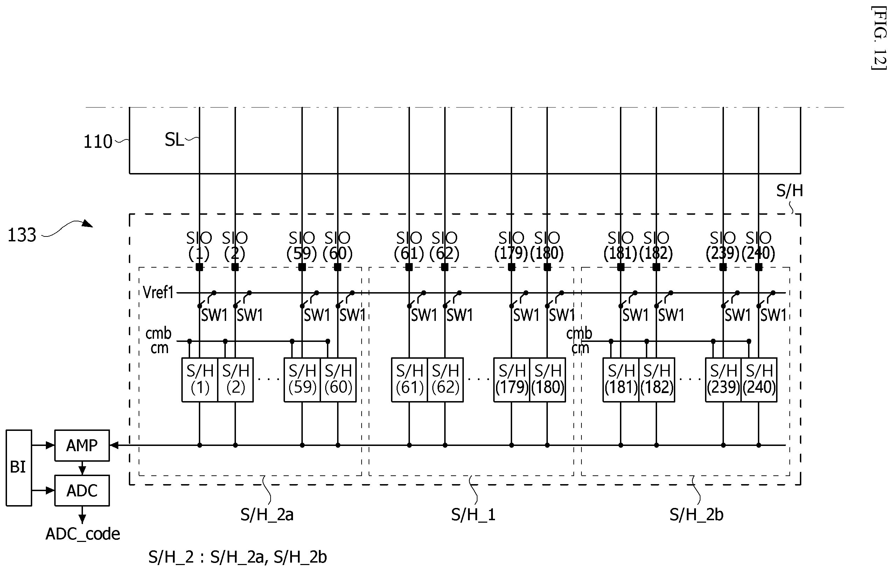

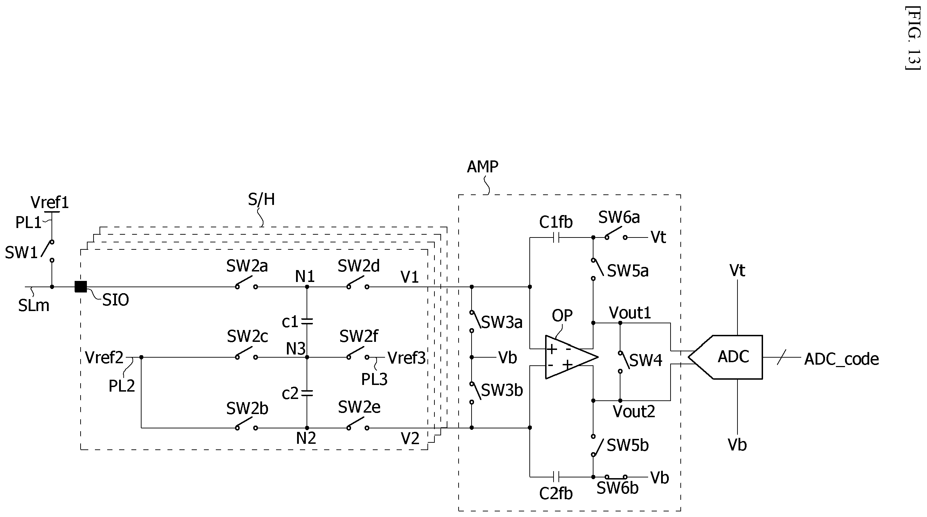

FIGS. 12 and 13 are diagrams illustrating a sensing circuit according to a second embodiment of the present invention.

Referring to FIGS. 12 and 13, a sensing circuit 133 according to the second embodiment of the present invention may include a bias part BI, a first switch SW1, a sample and hold part S/H, an amplifier AMP, and an AD converter ADC.

A configuration of the sensing circuit according to the second embodiment is the same as the configuration of the sensing circuit according to the first embodiment of FIG. 4, and a configuration of the sample and hold part shown in FIG. 13 is different from that of FIG. 5.

That is, in the second embodiment, first and second mode switches SW1a and SW1b are not disposed in a first sample and hold part S/H_1, which is always activated regardless of channel mode information, as shown in FIG. 13, whereas the first and second mode switches SW1a and SW1b are disposed only in second sample and hold parts S/H_2a and S/H_2b, which are selectively activated or deactivated according to the channel mode information, as shown in FIG. 5.

The first sample and hold part S/H_1 includes a plurality of sample and hold circuits, and the sample and hold circuits may include first to sixth sensing switches SW2a to SW2f, a first capacitor C1, and a second capacitor C2.

The first sensing switch SW2a is connected between a sensing channel SIO and a first connection node N1. The second sensing switch SW2b is connected between a second reference voltage line PL2 and a second connection node N2. The third sensing switch SW2c is connected between the second reference voltage line PL2 and a third connection node N3. The fourth sensing switch SW2d is connected between the first connection node N1 and a first input terminal + of the amplifier AMP. The fifth sensing switch SW2e is connected between the second connection node N2 and a second input terminal - of the amplifier AMP. The sixth sensing switch SW2f is connected between the third connection node N3 and a third reference voltage line PL3.

The first capacitor C1 is connected between the first connection node N1 and the third connection node N3. The second capacitor C2 is connected between the second connection node N2 and the third connection node N3.

The second sample and hold part S/H_2 includes a plurality of sample and hold circuits, and the sample and hold circuits have the same configuration and function as the sample and hold circuit of the first embodiment shown in FIG. 5.

Therefore, in the second embodiment, since there is no need to apply first and second mode control signals cmb and cm to the first sample and hold part S/H_1 as shown in FIG. 12, the first and second mode control signals cmb and cm are not applied to the first sample and hold part S/H_1 and are applied only to the second sample and hold parts S/H_2a and S/H_2b.

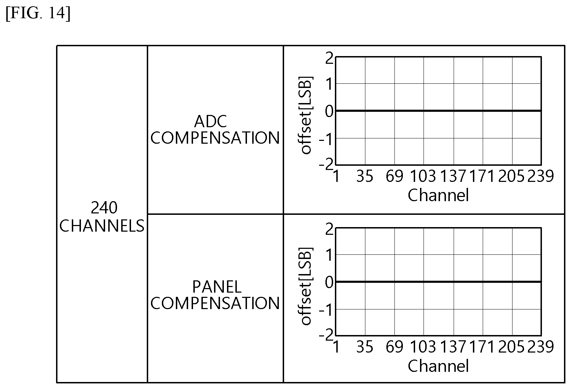

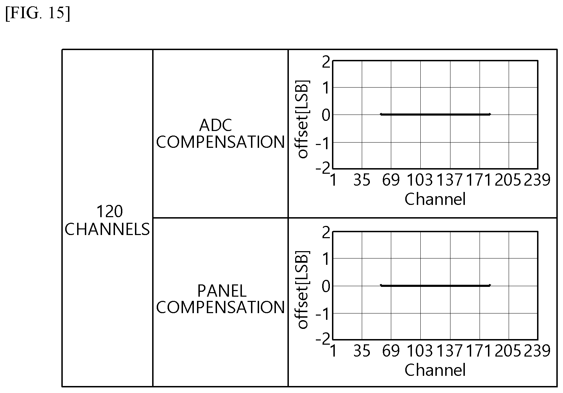

FIGS. 14 and 15 are diagrams illustrating offset values of the sample and hold part according to channels.

Referring to FIGS. 14 and 15, it can be confirmed that, when ADC compensation and panel compensation are performed according to the embodiments, all offset values of the sample and hold part using 240 sensing channels and offset values of the sample and hold part using 120 sensing channels are maintained constant.

Therefore, since the sample and hold part according to the embodiments can maintain a constant offset value, constant sensing characteristics can be obtained and uniform compensation performance between the channel modes can be secured.

According to the present invention, a formation in which some of sample and hold parts in a sensing circuits can be selectively activated or deactivated according to the number of sensing lines is applicable to display panels of various sizes or resolutions, and accurate sensing data can be obtained even when connected to only some of the sensing lines.

According to the present invention, compensation performance of the sensing circuit can be improved by simply adding a switch while minimizing a circuit configuration, thereby minimizing a design area and manufacturing costs for the circuit configuration.

According to the present invention, uniform compensation performance between an ADC compensation mode for compensating for an error of the sensing circuit and a panel compensation mode compensating for an electrical characteristic deviation of a pixel can be implemented.

It should be noted that effects of the present invention are not limited to the above-described effects, and other effects of the present invention will be apparent to those skilled in the art from the appended claims.

Although embodiments have been described in more detail with reference to the accompanying drawings, the present invention is not necessarily limited to these embodiments and may be variously modified without departing from the technical spirit of the present invention. The embodiments disclosed herein, therefore, are not to be taken in a sense for limiting the technical concept of the present invention but for explanation thereof, and the range of the technical concept of the present invention is not limited to these embodiments. Therefore, it should be understood that the above-described embodiments are not restrictive but illustrative in all aspects.

## Claims

1. A sensing circuit comprising:
a first switch connected between a first reference voltage line to which a first reference voltage is applied and each of a plurality of sensing lines;
a sample and hold part including a first sample and hold part configured to sample a voltage supplied through a sensing line connected to each of a plurality of first sensing channels and a second sample and hold part configured to sample a voltage supplied through a sensing line connected to at least one second sensing channel;
an amplifier configured to receive the sampled voltage from the sample and hold part and amplify the sampled voltage; and
an analog-digital (AD) converter configured to convert the amplified voltage into digital data and generate sensing data,
wherein the second sample and hold part is selectively activated according to a mode control signal.

2. The sensing circuit of claim 1, wherein the sample and hold part transmits a first voltage, which is sampled from a voltage supplied through the sensing line, and a second voltage, which is sampled from a second reference voltage applied through a second reference voltage line, to the amplifier.

3. The sensing circuit of claim 2, wherein:
the sample and hold part includes a plurality of sample and hold circuits connected to sensing channels; and
each of the plurality of sample and hold circuits includes:
a first mode switch connected between the sensing channel and a first connection node;
a second mode switch connected between the first connection node and the second reference voltage line;
a first sensing switch connected between the first connection node and a second connection node;
a second sensing switch connected between the second reference voltage line and a third connection node;
a third sensing switch connected between the second reference voltage line and a fourth connection node;
a fourth sensing switch connected between the second connection node and a first input terminal of the amplifier;
a fifth sensing switch connected between the third connection node and a second input terminal of the amplifier;
a first capacitor connected between the second connection node and the fourth connection node; and
a second capacitor connected between the third connection node and the fourth connection node.

4. The sensing circuit of claim 3, further comprising a sixth sensing switch connected between the fourth connection node and a third reference voltage line to which a third reference voltage is applied,
wherein the third reference voltage is set to a value that is smaller than that of the second reference voltage.

5. The sensing circuit of claim 3 or 4, wherein each of the plurality of sample and hold circuits is activated when the first mode switch is turned on and the second mode switch is turned off, and deactivated when the first mode switch is turned off and the second mode switch is turned on.

6. The sensing circuit of any one of claims 3 to 5, wherein each of the plurality of sample and hold circuits stores the first voltage in the first capacitor and the second voltage in the second capacitor when the first mode switch and the first to third sensing switches are turned on and the second mode switch and the fourth to sixth sensing switches are turned off.

7. The sensing circuit of claim 6, wherein, after the third sensing switch is turned on, the first and second sensing switches are turned on.

8. The sensing circuit of claim 6 or 7, wherein each of the plurality of sample and hold circuits transmits the first voltage to the first input terminal and the second voltage to the second input terminal when the first mode switch and the fourth and fifth sensing switches are turned on and the second mode switch and the first to third and sixth sensing switches are turned off.

9. The sensing circuit of any one of claims 2 to 8, wherein:
the first sample and hold part includes a plurality of first sample and hold circuits connected to sensing channels; and
each of the plurality of first sample and hold circuits includes:
a first sensing switch connected between the sensing channel and a first connection node;
a second sensing switch connected between the second reference voltage line and a second connection node;
a third sensing switch connected between the second reference voltage line and a third connection node;
a fourth sensing switch connected between the first connection node and a first input terminal of the amplifier;
a fifth sensing switch connected between the second connection node and a second input terminal of the amplifier;
a first capacitor connected between the first connection node and the third connection node; and
a second capacitor connected between the second connection node and the third connection node.

10. The sensing circuit of any one of claims 2 to 9, wherein:
the second sample and hold part includes a second sample and hold circuit connected to the sensing channel; and
the second sample and hold circuit includes:
a first mode switch connected between the sensing channel and a first connection node;
a second mode switch connected between the first connection node and the second reference voltage line;
a first sensing switch connected between the first connection node and a second connection node;
a second sensing switch connected between the second reference voltage line and a third connection node;
a third sensing switch connected between the second reference voltage line and a fourth connection node;
a fourth sensing switch connected between the second connection node and a first input terminal of the amplifier;
a fifth sensing switch connected between the third connection node and a second input terminal of the amplifier;
a first capacitor connected between the second connection node and the fourth connection node; and
a second capacitor connected between the third connection node and the fourth connection node.

11. A display device comprising:
a display panel in which pixels are disposed in regions in which a plurality of gate lines and a plurality of data lines intersect;
a gate driver configured to output a gate signal through the gate line;
a data driver configured to output a data voltage through the data line; and
a timing controller configured to control the gate driver and the data driver,
wherein the data driver includes a sensing circuit configured to detect electrical characteristics of the pixels and generate sensing data, and
the sensing circuit includes:
a first switch connected between a first reference voltage line to which a first reference voltage is applied and each of a plurality of sensing lines;
a sample and hold part including a first sample and hold part configured to sample a voltage supplied through a sensing line connected to each of a plurality of first sensing channels and a second sample and hold part configured to sample a voltage supplied through a sensing line connected to at least one second sensing channel;
an amplifier configured to receive the sampled voltage from the sample and hold part and amplify the sampled voltage; and
an analog-digital (AD) converter configured to convert the amplified voltage into digital data and generate sensing data,
wherein the second sample and hold part is selectively activated according to a mode control signal.

12. The display device of claim 11, wherein the data driver further includes a control circuit configured to generate the mode control signal using control data received from the timing controller and apply the mode control signal to the sensing circuit.

13. The display device of claim **11** or 12, wherein the sample and hold part transmits a first voltage, which is sampled from a voltage supplied through the sensing line, and a second voltage, which is sampled from a second reference voltage applied through a second reference voltage line, to the amplifier.

14. The display device of claim 13, wherein:
the sample and hold part includes a plurality of sample and hold circuits connected to sensing channels; and
each of the plurality of sample and hold circuits includes:
a first mode switch connected between the sensing channel and a first connection node;
a second mode switch connected between the first connection node and the second reference voltage line;
a first sensing switch connected between the first connection node and a second connection node;
a second sensing switch connected between the second reference voltage line and a third connection node;
a third sensing switch connected between the second reference voltage line and a fourth connection node;
a fourth sensing switch connected between the second connection node and a first input terminal of the amplifier;
a fifth sensing switch connected between the third connection node and a second input terminal of the amplifier;
a first capacitor connected between the second connection node and the fourth connection node; and
a second capacitor connected between the third connection node and the fourth connection node.

15. The display device of claim 14, further comprising a sixth sensing switch connected between the fourth connection node and a third reference voltage line to which a third reference voltage is applied,
wherein the third reference voltage is set to a value that is smaller than that of the second reference voltage.
